# EUROPÄISCHE PATENTSCHRIFT

(11) **EP 2 989 643 B1**
(45) Veröffentlichungstag und Bekanntmachung des Hinweises auf die Patenterteilung: **26.12.2018**
(21) Anmeldenummer: 14715557.6
(22) Anmeldetag: 24.03.2014
(51) Int. Cl.: H01C 1/14, H01C 17/28, H01B 1/02, H01C 1/144, H01L 23/00, H05B 3/86, H01C 7/04

(54) **VORRICHTUNG UND VERFAHREN ZUR HERSTELLUNG EINER ELEKTRISCH LEITFÄHIGEN UND MECHANISCHEN VERBINDUNG**
DEVICE AND METHOD FOR PRODUCING A CONDUCTIVE AND MECHANICAL CONNECTION
DISPOSITIF ET UNE MÉTHODE DE FABRICATION D'UNE CONNECTION CONDUCTRICE ET MÉCHANIQUE

(30) Priorität: 25.04.2013 DE 102013104207
(43) Veröffentlichungstag der Anmeldung: 02.03.2016
(73) Patentinhaber: TDK Electronics AG, 81671 München (DE)
(72) Erfinder: KLOIBER, Gerald, A-8073 Feldkirchen (AT); STRALLHOFER, Heinz, A-8530 Deutschlandsberg (AT)
(74) Vertreter: Epping - Hermann - Fischer
(86) Internationale Anmeldenummer: PCT/EP2014/055829
(87) Internationale Veröffentlichungsnummer: WO 2014/173595

(56) Entgegenhaltungen:
- EP-A1- 2 278 851
- WO-A1-2013/020863
- DE-A1-102006 050 291
- DE-A1-102011 016 935
- US-A- 4 286 249
- US-A1- 2011 085 929
- US-A1- 2011 266 666

## Beschreibung

Die vorliegende Erfindung betrifft eine Vorrichtung mit einem Grundkörper und einem Kontaktelement. Die vorliegende Erfindung betrifft weiterhin ein elektronisches Bauelement.

Das Dokument US 2011/266666 A1 beschreibt einen Halbleiterchip mit einer Elektrode aus Aluminium, an der ein Kontaktelement, das aus einem Stud Bump gefertigt wurde, angeordnet ist. Das Dokument US 4, 286,249 A beschreibt das Verbinden zweier Elemente mittels Punktschweißen. Das Dokument WO 2013/020863 A1 beschreibt verschiedene Verfahren zur Verbindung einer Elektrode mit einer leitfähigen Beschichtung, beispielsweise einen Autoklav-Prozess, bei dem durch die Einwirkung von Wärme und Druck ein elektrischer Kontakt erreicht wird. Das Dokument US 2011/085929 A1 beschreibt Diffusionsbonding zur Verbindung zweier Materialien, ohne dass hierfür weitere Materialien erforderlich sind, und wobei die Verbindung bei Temperaturen unterhalb einer Sinter- oder Schmelztemperatur der jeweiligen Materialien ermöglicht wird. Das Dokument EP 2278851 A1 beschreibt eine elektrisch beheizbare Glasscheibe, die eine elektrisch leitfähige Beschichtung auf der Oberfläche der Glasscheibe aufweist, sowie eine spezielle Kontaktierung dieser elektrisch leitfähigen Beschichtung. Das Dokument DE 10 2006 050291 A1 beschreibt einen Trägerstreifen, einen Halbleiterleistungsschalter sowie eine Halbleiterdiode. Der Trägerstreifen umfasst ein Chipfeld. Die Kathodenelektrode der Halbleiterdiode wird durch einen Verbindungsdraht elektrisch mit dem Chipfeld verbunden. Das Dokument DE 10 2011 016935 A1 beschreibt ein Verfahren zur Herstellung eines Halbleiterbauelements, bei dem ein Halbleiterchip auf einer Montagefläche eines Trägers angeordnet wird. Der Halbleiterchip wird unter anderem durch eine Drahtverbindung an einem Kontaktbereich der Montagefläche angeschlossen.
Eine zu lösende Aufgabe ist es, Maßnahmen anzugeben, die eine verbesserte, insbesondere elektrisch leitfähige und mechanische, Verbindung zwischen einem Grundkörper aufweisend eine Elektrode und einem Kontaktelement ermöglichen.
Die Aufgabe wird durch die Vorrichtung mit den Merkmalen des Patentanspruchs 1 sowie durch das Verfahren mit den Merkmalen des Patentanspruchs 6 gelöst. Vorteilhafte Ausgestaltungen und Weiterbildungen sind Gegenstand der abhängigen Patentansprüche.
Eine vorgeschlagene Vorrichtung umfasst einen Grundkörper aufweisend eine Elektrode und ein Kontaktelement, wobei das Kontaktelement direkt mechanisch und elektrisch leitfähig mit der Elektrode verbunden ist, um den Grundkörper und das Kontaktelement elektrisch leitfähig und mechanisch zu verbinden. Die elektrisch leitfähige und mechanische Verbindung ist vorzugsweise ohne weitere oder gesonderte Verbindungselemente oder Verbindungsmittel, abgesehen von dem die Elektroden aufweisenden Grundkörper und dem Kontaktelement, gebildet.
In einer Ausgestaltung umfasst das Material der Elektrode ein Edelmetall, beispielsweise Gold. Weiterhin kann die Elektrode aus einem Edelmetall, beispielsweise Gold bestehen. Weiterhin kann die Elektrode ein Halbedelmetall umfassen oder daraus bestehen.
In einer Ausgestaltung umfasst das Material des Kontaktelements ein Edelmetall, beispielsweise Gold, oder ein Halbedelmetall.
In einer Ausgestaltung besteht das Kontaktelement aus einem Edelmetall, beispielsweise Gold, oder aus einem Halbedelmetall.

Die Verbindung weist zwischen der Elektrode und dem Kontaktelement mehrere lokale, voneinander abgegrenzte Verbindungsbereiche auf. Die direkte mechanische und elektrisch leitfähige Verbindung zwischen der Elektrode und dem Kontaktelement ermöglicht mit Vorteil eine technisch besonders einfache und/oder kostengünstige Ausbildung der Verbindung.

Die Verbindung weist eine Vielzahl von lokalen, voneinander abgegrenzten Verbindungsbereichen auf. Diese Verbindungsbereiche sind in einem Anschlussbereich der Vorrichtung angeordnet. Der Anschlussbereich bildet einen zusammenhängenden Bereich, indem die Verbindungsbereiche angeordnet sind. Die Verbindungsbereiche können räumlich voneinander getrennt oder derart angeordnet sein, dass die Verbindungsbereiche nicht zusammenhängend sind. Diese Ausgestaltung ermöglicht mit Vorteil eine technisch besonders einfache und/oder kostengünstige Ausbildung der Verbindung.

Der oder die Verbindungsbereiche der Verbindung bezeichnen vorzugsweise Bereiche oder Flächen der Vorrichtung in denen die elektrische und mechanische Verbindung ausgebildet ist.

In einer Ausgestaltung weist die Verbindung zwischen der Elektrode und dem Kontaktelement einen zusammenhängenden Verbindungsbereich auf. Dies ermöglicht mit Vorteil die Ausbildung einer besonders stabilen mechanischen und/oder niederohmigen elektrisch leitfähigen Verbindung.

In Falle der Ausgestaltung der Verbindung mit einem zusammenhängenden Verbindungsbereich deckt sich der Anschlussbereich vorzugsweise mit dem Verbindungsbereich.

In einer bevorzugten Ausgestaltung ist die Verbindung durch eine stoffschlüssige Diffusionsverbindung zwischen dem Elektrodenmaterial und dem Material des Kontaktelements gebildet. Diese Ausgestaltung ermöglicht mit Vorteil eine mechanische Verbindung zwischen der Elektrode und dem Kontaktelement.

Die Diffusionsverbindung ist vorzugsweise durch eine Materialdiffusion, besonders bevorzugt durch eine Feststoffdiffusion von Material der Elektrode in das Material des Kontaktelements oder umgekehrt gebildet, so dass sich die Verbindung durch einen Stoffschluss zwischen dem Elektrodenmaterial und dem Material des Kontaktelements ausbildet.

In einer bevorzugten Ausgestaltung ist die Verbindung frei von Aufschmelzbereichen der an der Verbindung beteiligten Materialien der Elektroden und des Kontaktelements. Durch diese Ausgestaltung kann die Verbindung vorzugsweise besonders einfach, insbesondere bei der Herstellung der Verbindung ohne ein Aufschmelzen des Elektrodenmaterials und/oder des Materials des Kontaktelements, hergestellt werden.

Bezugnahmen auf und/oder Schmelzpunkte der Materialien des Kontaktelements und der Elektrode beziehen sich vorliegend lediglich auf die Fügematerialien, d.h. die Materialien des Kontaktelements und der Elektrode, welche an der Verbindung beteiligt sind beziehungsweise für diese angeboten werden. Das Kontaktelement und die Elektrode können weiterhin jeweils von den Fügematerialien verschiedene Materialien aufweisen.

Bei elektrischen Schweißverbindungen werden die zu verbindenden Materialien zur Herstellung einer stoffschlüssigen und elektrisch leitfähigen Verbindung üblicherweise aufgeschmolzen, wobei lokal hohe Temperaturen erforderlich sind. Dies kann zu einer sehr starken Belastung, beispielsweise für das so kontaktierte Bauelement und zu Schädigungen des Bauelements führen. Diese Nachteile können durch die vorgestellte Verbindung dadurch umgangen werden, dass die Verbindung ohne die Beteiligung von Aufschmelzbereichen und/oder von hohen Temperaturen ausgebildet werden kann.

In einer bevorzugten Ausgestaltung ist die Verbindung verbindungsmaterialfrei, beispielsweise lotmaterialfrei, realisiert. Dies ermöglicht die Ausbildung oder Herstellung der Verbindung ohne jegliche Verbindungsmaterialien, beispielsweise Lotmaterialien, wodurch die Ausbildung oder Herstellung der Verbindung beispielsweise gegenüber Lötverbindungen oder sonstigen Verbindungen, welche ein Verbindungsmaterial aufweisen, vereinfacht werden kann.

Ein Vorteil der vorgestellten Verbindung bezieht sich darauf, dass Nachteile, die beispielsweise mit einer Lötverbindung zwischen dem Kontaktelement und der Elektrode verbunden wären, bei der vorgestellten Verbindung nicht auftreten. Bei elektrischen Kontaktierungen kommt häufig hochschmelzendes Lot (mit einem Schmelzpunkt von über 300 °C) mit einem hohen Bleigehalt von mehr als 90% zum Einsatz. Weiterhin sind auch Bauelemente mit einer elektrischen Kontaktierung mit bleifreier Lötung auf Zinnbasis verfügbar. Nachteile dieser Verbindungen betreffen Empfindlichkeiten gegenüber einer Migration der genannten Lotmaterialien. In nasser Umgebung und/oder bei Anliegen einer elektrischen Spannung kommt es häufig zu Migration von Metallionen aus dem Lot und/oder der Elektrode. Besonders migrierfähig sind insbesondere Silber, beispielsweise aus der Elektrode und Blei aus dem Lot.

In einer bevorzugten Ausgestaltung weist eine Oberfläche des Kontaktelements, die der Elektrode zugewandt ist, in einem Anschlussbereich, in der die Verbindung ausgebildet ist, einen Edelmetalloberflächenbereich auf. Diese Ausgestaltung ermöglicht mit Vorteil eine besonders einfache Herstellung der Verbindung zwischen dem Kontaktelement und der Elektrode, da durch die Gediegenheit der Edelmetalle an einer Oberfläche des Kontaktelements die Ausbildung von unerwünschten Oxidschichten an der Oberfläche des Kontaktelements verhindert werden kann. Solche Oxidschichten können die elektrischen Eigenschaften einer elektrischen Verbindung negativ beeinflussen. Alternativ kann auf eine Schutzgasatmosphäre, welche ebenfalls das Ausbilden von schädigenden Oxidschichten verhindern kann, bei der Herstellung der elektrischen Verbindung verzichtet werden.

In einer bevorzugten Ausgestaltung ist das Kontaktelement aus Nickel oder umfasst Nickel.

In einer bevorzugten Ausgestaltung ist das Kontaktelement in einem Anschlussbereich mit einem Edelmetall beschichtet.

In einer bevorzugten Ausgestaltung ist das Kontaktelement in dem Anschlussbereich teilweise mit einem Edelmetall beschichtet. Diese Ausgestaltung ermöglicht mit Vorteil eine besonders kostengünstige Herstellung der Verbindung beziehungsweise der Vorrichtung.

Der Anschlussbereich kann Abmessungen von wenigen Millimetern, beispielsweise 5 mm aufweisen.

In einer bevorzugten Ausgestaltung ist das Kontaktelement ein Draht. Durch diese Ausgestaltung kann der Grundkörper besonders zweckmäßig über das Kontaktelement mit einer weiteren Komponente mechanisch oder elektrisch verbunden werden. Gemäß dieser Ausgestaltung beträgt die Länge des Kontaktelements vorzugsweise einige Zentimeter, beispielsweise 5 cm.

In einer Ausgestaltung ist das Kontaktelement ohne Abflachung ausgebildet.

In einer Ausgestaltung weist das Kontaktelement eine Isolierung auf. Die Isolierung ist vorzugsweise außerhalb des Anschlussbereichs angeordnet. Durch diese Ausgestaltung kann das Kontaktelement, mit Vorteil gegenüber äußeren Einflüssen elektrisch isoliert werden.

In einer bevorzugten Ausgestaltung ist das Kontaktelement in dem Bereich, in dem die Verbindung ausgebildet ist, beispielsweise bandartig abgeflacht. Dies ermöglicht mit Vorteil die Ausbildung eines möglichst großen Anschlussbereichs des Kontaktelements.

Es wird weiterhin ein elektronisches Bauelement angegeben, welches die Vorrichtung umfasst. Das elektronische Bauelement kann weiterhin die Vorrichtung darstellen. Vorzugsweise ist das elektronische Bauelement die Vorrichtung.

In einer bevorzugten Ausgestaltung des elektronischen Bauelements enthält der Grundkörper eine Keramik, beispielsweise eine NTC-Keramik, oder weist einen Halbleiterkörper auf.

In einer bevorzugten Ausgestaltung des elektronischen Bauelements weist das elektronische Bauelement zusätzlich eine Umhüllung um die Verbindung auf. Die Umhüllung ist derart angeordnet und ausgebildet, dass sie die Verbindung vor der Einwirkung äußerer Kräfte schützt. Die Umhüllung schützt die Verbindung vorzugsweise vor der Einwirkung äußerer mechanischer Kräfte. Die Umhüllung kann beispielsweise einen Formkörper zur mechanischen Stabilisierung der Verbindung umfassen.

Es wird weiterhin ein Verfahren zur Herstellung einer elektrisch leitfähigen und mechanischen Verbindung zwischen einem Grundkörper aufweisend eine Elektrode und einem Kontaktelement angegeben. Die oben beschriebene Verbindung ist vorzugsweise mittels des hier beschriebenen Verfahrens herstellbar oder hergestellt. Insbesondere können sich sämtliche für das Verfahren offenbarte Merkmale auch auf die oben beschriebene Vorrichtung, das elektronische Bauelement und/oder die Verbindung beziehen. Der Grundkörper, die Elektrode und das Kontaktelement beziehen sich vorzugsweise auf die oben schon genannten Komponenten. Das Verfahren umfasst die Schritte des Bereitstellens des Grundkörpers mit der Elektrode und des Bereitstellens des Kontaktelements. Das Verfahren umfasst weiterhin das direkte mechanische Inkontaktbringen der Elektrode und des Kontaktelements in einem Kontaktbereich. Das Verfahren umfasst weiterhin das Beaufschlagen des Kontaktbereichs mit einer mechanischen Kraft und mit Wärme, so dass die elektrisch leitfähige und mechanische Verbindung zwischen der Elektrode und dem Kontaktelement in dem Kontaktbereich ausgebildet wird. Der Kontaktbereich bezieht sich vorzugsweise auf einen mechanischen Kontakt zwischen der Elektrode und dem Kontaktelement.

Die mechanische Kraft ist vorzugsweise kleiner als eine Verformungskraft des Kontaktelements. Die Verformungskraft bezieht sich weiterhin vorzugsweise auf eine signifikante und/oder plastische Verformung des Kontaktelements.

In einer bevorzugten Ausgestaltung wird der Kontaktbereich ohne weitere Verbindungsmittel mit der mechanischen Kraft und mit Wärme beaufschlagt, so dass die Verbindung zwischen der Elektrode und dem Kontaktelement in dem Kontaktbereich ausgebildet wird.

Das Beaufschlagen des Kontaktbereichs mit einer mechanischen Kraft und mit Wärme bezieht sich vorzugsweise auf die Anwendung einer mechanischen Kraft des Kontaktbereichs und eine Wärmebehandlung. Bevorzugt bezieht sich das Beaufschlagen mit Wärme oder die Anwendung oder Behandlung mit Wärme auf Temperaturen oberhalb einer Raumtemperatur, Umgebungstemperatur oder Standardtemperatur.

In einer Ausgestaltung wird die Elektrode in dem Kontaktbereich mit der mechanischen Kraft beaufschlagt, so dass die Verbindung zwischen der Elektrode und dem Kontaktelement ausgebildet wird. In einer Ausgestaltung wird das Kontaktelement in dem Kontaktbereich mit der mechanischen Kraft beaufschlagt, so dass die Verbindung zwischen der Elektrode und dem Kontaktelement ausgebildet wird.

In einer bevorzugten Ausgestaltung wird der Kontaktbereich zur Ausbildung der Verbindung ausschließlich mit der mechanischen Kraft und mit Wärme beaufschlagt. Diese Ausgestaltung ermöglicht mit Vorteil eine besonders einfache Ausgestaltung der Verbindung nur mit mechanischer Kraft und mit Wärme ohne weitere Einflüsse.

In einer bevorzugten Ausgestaltung überlappt der Anschlussbereich zumindest teilweise mit dem Kontaktbereich. Vorzugsweise decken sich der Anschlussbereich und der Kontaktbereich großflächig.

In einer bevorzugten Ausgestaltung sind die Temperatur für die Wärmebeaufschlagung und die mechanische Kraft derart gewählt, dass eine Diffusion von Material stattfindet, wodurch das Kontaktelement mechanisch stabil mit der Elektrode verbunden wird. Dabei kann Elektrodenmaterial in das Kontaktelement oder das Material des Kontaktelements diffundieren. Zusätzlich oder alternativ kann das Material des Kontaktelements in das Elektrodenmaterial diffundieren. Die Diffusion betrifft vorzugsweise eine Feststoffdiffusion, wobei keine flüssige Phase von Elektrodenmaterial und keine flüssige Phase von dem Material des Kontaktelements, beteiligt ist. Insbesondere findet bei der Herstellung oder Ausbildung der Verbindung kein Schmelzen der genannten Materialien statt.

In einer bevorzugten Ausgestaltung liegt die Temperatur für die Wärmebeaufschlagung unterhalb der Schmelztemperatur des Elektrodenmaterials.

In einer bevorzugten Ausgestaltung liegt die Temperatur für die Wärmebeaufschlagung unterhalb der Schmelztemperatur des für die Verbindung angebotenen Materials des Kontaktelements. Durch diese Ausgestaltung kann weiterhin eine besonders einfache Ausbildung oder Herstellung der Verbindung erreicht werden, da bei einer entsprechenden Herstellung der Verbindung auf ein prozesstechnisch aufwendiges Aufschmelzen des Elektrodenmaterials und/oder des für die Verbindung angebotene Materials des Kontaktelements verzichtet werden kann.

In einer bevorzugten Ausgestaltung beträgt die mechanische Kraft zwischen 5 Newton und 10 Newton.

In einer bevorzugten Ausgestaltung wird die Wärmebeaufschlagung bei Temperaturen zwischen 350 °C und 550 °C durchgeführt.

In einer bevorzugten Ausgestaltung umfasst das Verfahren nach dem direkten mechanischen Verbinden das Umhüllen der Verbindung, beispielsweise mit einem Formkörper zur mechanischen Stabilisierung des Kontaktelements.

Die Verbindung verbindet vorzugsweise das Kontaktelement und die Elektrode mechanisch derart stabil, dass bis zu dem Umhüllen der Verbindung eine elektrisch leitfähige Verbindung zwischen der Elektrode und dem Kontaktelement besteht.

Das Umhüllen der Verbindung ermöglicht mit Vorteil eine Weiterbearbeitung der Vorrichtung und ein Aussetzen der Verbindung mit mechanischen äußeren Kräften, welche größer sind als eine Halte- oder Verbindungskraft der Verbindung.

Die Verbindungskraft kann abhängig von der Geometrie und/oder dem Flächeninhalt des oder der Verbindungsbereiche der Verbindung sein.

Die Verbindungskraft kann Werte zwischen 0,1 N und 10 N, beispielsweise einen Wert von 1 N, annehmen. Die Gesamtfläche des oder der Verbindungsbereiche kann Werte zwischen 0,1 mm² und 10 mm², beispielsweise einen Wert von 1 mm², annehmen.

In einer bevorzugten Ausgestaltung liegt die Temperatur für die Wärmebehandlung unterhalb des niedrigsten Schmelzpunkts des Elektrodenmaterials und des für die Verbindung angebotenen Materials des Kontaktelements.

Der niedrigste Schmelzpunkt kann ein Minimum der Schmelzpunkte des Elektrodenmaterials und des für die elektrische Verbindung angebotenen Materials des Kontaktelements betreffen.

Weitere Vorteile, vorteilhafte Ausgestaltungen und Zweckmäßigkeiten der Erfindung ergeben sich aus der folgenden Beschreibung der Ausführungsbeispiele in Verbindung mit den Figuren.
- Figur 1: zeigt eine schematische Ansicht einer Vorrichtung.
- Figur 2: zeigt eine schematische Aufsicht auf die Vorrichtung.
- Figur 3: zeigt eine schematische Seitenansicht der Vorrichtung.

Gleiche, gleichartige und gleich wirkende Elemente sind in den Figuren mit gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

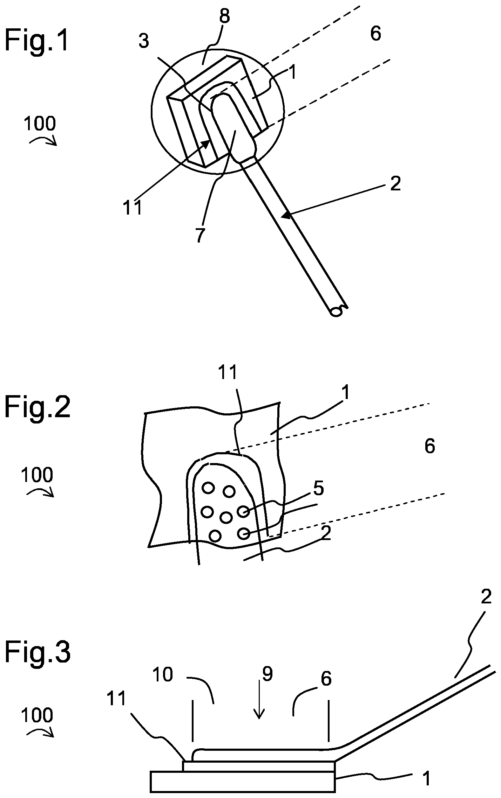

Figur 1 zeigt eine Vorrichtung 100 mit einem Grundkörper 1. Der Grundkörper 1 kann beispielsweise ein Sensorkopf, eine, insbesondere gesinterte und gepresste, NTC-Keramik in Form einer Scheibe, ein Halbleiterkörper oder der Grundkörper einer dieser Elemente sein. Der Halbleiterkörper kann dabei rund oder eckig sein. Die Vorrichtung kann Teil eines elektronischen Bauelements (in den Figuren nicht explizit dargestellt) sein. Vorzugsweise ist das elektronische Bauelement die Vorrichtung.

Der Grundkörper 1 weist eine Elektrode 11 auf. Die Elektrode 11 ist vorzugsweise als Elektrodenschicht auf dem Grundkörper 1 aufgebracht. Die Vorrichtung 100 weist weiterhin ein Kontaktelemente 2 auf, welches direkt mechanisch und elektrisch leitfähig mit der Elektrode 11 verbunden ist, um eine Verbindung 3 zwischen dem Grundkörper 1 und dem Kontaktelement 2 zu bilden.

Das Kontaktelement 2 ist vorzugsweise ein Draht. Das Kontaktelement 2 weist weiterhin an einem dem Grundkörper 1 zugewandten Ende eine Abflachung 7 auf. Die Abflachung 7 kann bandartig ausgebildet sein. Die Abflachung 7 erstreckt sich vorzugsweise über einen Bereich, in dem das Kontaktelement 2 elektrisch leitfähig mit der Elektrode 11 verbunden ist beziehungsweise in dem die Verbindung 3 ausgebildet ist.

Alternativ kann das Kontaktelement ohne Abflachung ausgestaltet sein. Das Kontaktelement kann weiterhin mit einer Isolierung (in den Figuren nicht explizit dargestellt) versehen sein.

Die Isolierung kann in Bereichen des Kontaktelements angeordnet sein, in denen das Kontaktelement keine Abflachung aufweist.

Das Kontaktelement 2 ist weiterhin in einem Anschlussbereich 6 elektrisch leitfähig und mechanisch direkt mit der Elektrode 11 verbunden. Vorzugsweise ist die oben genannte Abflachung 7 in dem Anschlussbereich 6 angeordnet. Die Isolierung ist zweckmäßigerweise außerhalb des Anschlussbereichs 6 angeordnet.

Vorzugsweise weist eine Oberfläche des Kontaktelements 2, die der Elektrode 11 zugewandt ist, in dem Anschlussbereich 6, einen Edelmetalloberflächenbereich auf. Das Kontaktelement 2 kann in dem Anschlussbereich 6 mit einem Edelmetall beschichtet sein. Das Kontaktelement 2 kann in dem Anschlussbereich 6 weiterhin mit einem Halbedelmetall beschichtet sein.

Obwohl dies in den Figuren nicht explizit dargestellt ist, kann die Vorrichtung ein oder mehrere weitere Kontaktelement aufweisen. Dabei kann der Grundkörper eine oder mehrere weitere Elektroden aufweisen, die jeweils mit einem der weiteren Kontaktelemente elektrisch leitfähig und direkt mechanisch verbunden sind, um weitere Verbindungen zu bilden.

Vorzugsweise ist die Verbindung 3 in dem Anschlussbereich ausgebildet. Die Verbindung 3 ist vorzugsweise durch eine stoffschlüssige Diffusionsverbindung zwischen dem Elektrodenmaterial der Elektrode 11 und dem Material des Kontaktelements 2 gebildet. Die Verbindung 3 ist vorzugsweise frei von Aufschmelzbereichen der an der Verbindung 3 beteiligten Materialien der Elektrode 11 und des Kontaktelements 2. Ebenfalls ist die Verbindung 3 vorzugsweise frei von Verbindungsmaterialien, beispielsweise frei von Lotmaterialien realisiert. In Figur 1 ist das Kontaktelement 2 als Draht dargestellt. Weiterhin ist in Figur 1 eine Umhüllung 8 dargestellt, welche den Grundkörper 1 und einen Teil des Kontaktelements 2 umhüllt und vorzugsweise mechanisch stabilisiert.

Figur 2 zeigt zusätzlich zur Figur 1 lokale, voneinander abgegrenzte Verbindungsbereiche 5, die vorzugsweise die Verbindung zwischen der Elektrode und dem Kontaktelement herstellen. Die lokalen Verbindungsbereiche 5 stellen vorzugsweise die direkte mechanische und elektrisch leitfähige Verbindung zwischen Kontaktelement und der Elektrode 11 her. Dabei sind die lokalen Verbindungsbereiche 5 durch eine stoffschlüssige Diffusionsverbindung von Elektrodenmaterial und dem Material des Kontaktelements 2 hergestellt. Die lokalen Verbindungsbereiche 5 sind weiterhin räumlich voneinander getrennt beziehungsweise räumlich nicht zusammenhängend angeordnet.

Anders als in Figur 2 dargestellt kann auch nur ein zusammenhängender Verbindungsbereich existieren, welcher die direkte mechanische und elektrisch leitfähige Verbindung zwischen dem Kontaktelement und der Elektrode herstellt.

Figur 3 zeigt eine Seitenansicht der Vorrichtung 100. Es ist ein Kontaktbereich 10 gezeigt, in dem zur Herstellung der Verbindung 3 eine durch den Pfeil 9 angedeutete mechanische Kraft zur Herstellung der Verbindung 3 in dem Kontaktbereich 10 angelegt wird beziehungsweise der Kontaktbereich mit dieser beaufschlagt wird. Vorzugsweise ist die Verbindung 3 in dem Kontaktbereich 10 ausgebildet. Bei der Beaufschlagung der mechanischen Kraft wirkt die Kraft 9 vorzugsweise relativ zwischen dem Grundkörper 1 mit der Elektrode 11 und dem Kontaktelement 2. Es kann hierbei der Grundkörper fixiert oder festgehalten werden, wobei das Kontaktelement direkt mit der Kraft 9 beaufschlagt wird oder umgekehrt. Die mechanische Kraft kann zwischen 5 N und 10 N betragen. Vorzugsweise überdeckt sich der Kontaktbereich 10 mit dem Anschlussbereich 6.

Weiterhin wird der Kontaktbereich 10 mit Wärme beaufschlagt oder behandelt. Dies kann bei Temperaturen zwischen 350°C und 550°C, beispielsweise bei 450°C erfolgen.

Vorzugsweise wird der Kontaktbereich 10 zur Ausbildung der Verbindung ausschließlich mit der mechanischen Kraft und mit Wärme beaufschlagt. Die Temperatur der Wärmebeaufschlagung und die mechanische Kraft sind vorzugsweise derart gewählt, dass eine Diffusion von Material (Elektrodenmaterial und Material des Kontaktelements) stattfindet, wodurch das Kontaktelement mechanisch stabil mit der Elektrode verbunden wird.
Durch das genannte Verfahren kann die Prozesstemperatur zur Herstellung der Verbindung signifikant unterhalb des Schmelzpunktes der beteiligten Materialien oder Metalle gehalten werden.
Die Verbindung ist vorzugsweise elektrisch niederohmig. Der Ausdruck "niederohmig" kann sich auf elektrische Widerstände zwischen einem oder mehreren Mikroohm (µΩ) bis zu einem oder mehreren Milliohm (mΩ) beziehen.

### Bezugszeichenliste

- 1: Grundkörper
- 2: Kontaktelement
- 3: Verbindung
- 5: Lokale Verbindungsbereiche
- 6: Anschlussbereich
- 7: Abflachung
- 8: Umhüllung
- 9: Kraft
- 10: Kontaktbereich
- 11: Elektrode

- 100: Vorrichtung

## Patentansprüche

1. Vorrichtung (100) mit einem Grundkörper (1) aufweisend eine Elektrode (11) und mit einem Kontaktelement (2), wobei das Kontaktelement (2) direkt mechanisch und elektrisch leitfähig mit der Elektrode (11) verbunden ist, um den Grundkörper (1) und das Kontaktelement (2) elektrisch leitfähig und mechanisch zu verbinden, wobei die elektrische und mechanische Verbindung (3) zwischen der Elektrode (11) und dem Kontaktelement frei von Aufschmelzbereichen der an der Verbindung (3) beteiligten Materialien der Elektrode (11) und des Kontaktelements (2) ist, wobei die Verbindung (3) verbindungsmaterialfrei realisiert ist,
wobei die Verbindung durch eine stoffschlüssige Diffusionsverbindung zwischen dem Elektrodenmaterial und dem Material des Kontaktelements gebildet ist,
wobei das Kontaktelement (2) ein Draht ist, der einen Anschlussbereich (6) aufweist, in dem er elektrisch leitfähig und mechanisch direkt mit der Elektrode (11) verbunden ist,
wobei die Verbindung (3) zwischen der Elektrode (11) und dem Kontaktelement (2) mehrere lokale, voneinander abgegrenzte Verbindungsbereiche (5) aufweist, und wobei der Anschlussbereich (6) einen zusammenhängenden Bereich bildet, in dem die Verbindungsbereiche (5) angeordnet sind.

2. Vorrichtung (100) nach Anspruch 1, wobei eine Oberfläche des Kontaktelements (2), die der Elektrode zugewandt ist, in einem Anschlussbereich (6), in der die Verbindung (3) ausgebildet ist, einen Edelmetalloberflächenbereich aufweist.

3. Vorrichtung (100) nach Anspruch 1 oder 2, wobei das Kontaktelement (2) in dem Bereich, in dem die Verbindung (3) ausgebildet ist, abgeflacht (7) ist.

4. Elektronisches Bauelement, mit einer Vorrichtung nach mindestens einem der vorhergehenden Ansprüche, wobei der Grundkörper (1) eine Keramik enthält oder einen Halbleiterkörper aufweist.

5. Elektronisches Bauelement, mit einer Vorrichtung nach mindestens einem der Ansprüche 1 bis 3, welches zusätzlich eine Umhüllung (8) um die Verbindung (3) aufweist, wobei die Umhüllung (8) derart angeordnet und ausgebildet ist, dass sie die Verbindung (3) vor der Einwirkung äußerer Kräfte schützt.

6. Verfahren zur Herstellung einer elektrisch leitfähigen und mechanischen Verbindung zwischen einem Grundkörper (1) aufweisend eine Elektrode (11) und einem Kontaktelement (2) mit folgenden Schritten:
- Bereitstellen des Grundkörpers (1) mit der Elektrode (11) und Bereitstellen des Kontaktelements (2),
- direktes mechanisches Inkontaktbringen der Elektrode (11) und des Kontaktelements (2) in einem Kontaktbereich (10),
- Beaufschlagen des Kontaktbereichs (10) mit einer mechanischen Kraft und mit Wärme, so dass die elektrisch leitfähige und mechanische Verbindung (3) zwischen der Elektrode (11) und dem Kontaktelement (10) in dem Kontaktbereich (10) ausgebildet wird,
wobei die Verbindung durch eine stoffschlüssige Diffusionsverbindung zwischen dem Elektrodenmaterial und dem Material des Kontaktelements gebildet ist,
wobei das Kontaktelement (2) ein Draht ist, der einen Anschlussbereich (6) aufweist, in dem er elektrisch leitfähig und mechanisch direkt mit der Elektrode (11) verbunden ist,
wobei die Verbindung (3) zwischen der Elektrode (11) und dem Kontaktelement (2) mehrere lokale, voneinander abgegrenzte Verbindungsbereiche (5) aufweist, und wobei der Anschlussbereich (6) einen zusammenhängenden Bereich bildet, in dem die Verbindungsbereiche (5) angeordnet sind.

7. Verfahren nach Anspruch 6, wobei der Kontaktbereich (10) zur Ausbildung der Verbindung (3) ausschließlich mit der mechanischen Kraft und Wärme beaufschlagt wird.

8. Verfahren nach Anspruch 6 oder 7, wobei die Temperatur der Wärmebeaufschlagung und die mechanische Kraft derart gewählt sind, dass eine Diffusion von Material stattfindet, wodurch das Kontaktelement (2) mechanisch stabil und elektrisch leitfähig mit der Elektrode (11) verbunden wird.

9. Verfahren nach mindestens einem der Ansprüche 6 bis 8, wobei die Temperatur für die Wärmebeaufschlagung unterhalb der Schmelztemperatur des Elektrodenmaterials und/oder unterhalb der Schmelztemperatur des für die Verbindung (3) angebotenen Materials des Kontaktelements (2) liegt.

10. Verfahren nach mindestens einem der Ansprüche 6 bis 9, wobei die Wärmebeaufschlagung bei Temperaturen zwischen 350 °C und 550 °C durchgeführt wird.

11. Verfahren nach mindestens einem der Ansprüche 6 bis 10, welches nach dem direkten mechanischen Verbinden das Umhüllen der Verbindung (3), beispielsweise mit einem Formkörper (8) zur mechanischen Stabilisierung des Kontaktelements (2), umfasst.

## Claims

1. Apparatus (100) comprising a main body (1) having an electrode (11) and comprising a contact element (2), wherein the contact element (2) is directly mechanically and electrically conductively connected to the electrode (11) in order to electrically conductively and mechanically connect the main body (1) and the contact element (2), wherein the electrical and mechanical connection (3) between the electrode (11) and the contact element is free of melting regions of the materials of the electrode (11) and of the contact element (2) which are involved in the connection (3), wherein the connection (3) is realized in a manner free of connection material,
wherein the connection is formed by a cohesive diffusion connection between the electrode material and the material of the contact element, wherein the contact element (2) is a wire which has a connecting region (6) in which it is electrically conductively and mechanically directly connected to the electrode (11), wherein the connection (3) has a plurality of local connection regions (5) delimited from one another between the electrode (11) and the contact element (2), and wherein the connecting region (6) forms a continuous region in which the connection regions (5) are arranged.

2. Apparatus (100) according to Claim 1, wherein a surface of the contact element (2) which faces the electrode has a noble metal surface region in a connecting region (6) in which the connection (3) is formed.

3. Apparatus (100) according to Claim 1 or 2, wherein the contact element (2) is flattened (7) in the region in which the connection (3) is formed.

4. Electronic component, comprising an apparatus according to at least one of the preceding claims, wherein the main body (1) contains a ceramic or comprises a semiconductor body.

5. Electronic component, comprising an apparatus according to at least one of Claims 1 to 3, which additionally comprises an encapsulation (8) around the connection (3), wherein the encapsulation (8) is arranged and formed in such a way that it protects the connection (3) against the action of external forces.

6. Method for producing an electrically conductive and mechanical connection between a main body (1) having an electrode (11) and a contact element (2), comprising the following steps:
- providing the main body (1) having the electrode (11) and providing the contact element (2),
- directly mechanically contacting the electrode (11) and the contact element (2) in a contact region (10),
- applying a mechanical force and heat to the contact region (10), such that the electrically conductive and mechanical connection (3) between the electrode (11) and the contact element (2) is formed in the contact region (10),
wherein the connection is formed by a cohesive diffusion connection between the electrode material and the material of the contact element,
wherein the contact element (2) is a wire which has a connecting region (6) in which it is electrically conductively and mechanically directly connected to the electrode (11),
wherein the connection (3) has a plurality of local connection regions (5) delimited from one another between the electrode (11) and the contact element (2), and wherein the connecting region (6) forms a continuous region in which the connection regions (5) are arranged.

7. Method according to Claim 6, wherein exclusively the mechanical force and heat are applied to the contact region (10) for the purpose of forming the connection (3).

8. Method according to Claim 6 or 7, wherein the temperature for the application of heat and the mechanical force are chosen in such a way that a diffusion of material takes place, whereby the contact element (2) is mechanically stably and electrically conductively connected to the electrode (11).

9. Method according to at least one of Claims 6 to 8,
wherein the temperature for the application of heat is below the melting point of the electrode material and/or below the melting point of the material of the contact element (2) that is offered for the connection (3).

10. Method according to at least one of Claims 6 to 9,
wherein the application of heat is carried out at temperatures of between 350°C and 550°C.

11. Method according to at least one of Claims 6 to 10 which comprises, after the direct mechanical connection, the encapsulation of the connection (3), for example with a shaped body (8) for mechanically stabilizing the contact element (2).

## Revendications

1. Dispositif (100), comprenant un corps de base (1) qui possède une électrode (11) et comprenant un élément de contact (2), l'élément de contact (2) étant relié directement à l'électrode (11), mécaniquement et de manière électriquement conductrice, afin de relier le corps de base (1) et l'élément de contact (2) de manière électriquement conductrice et mécaniquement, la liaison électrique et mécanique (3) entre l'électrode (11) et l'élément de contact étant dépourvue de zones de fusion des matières de l'électrode (11) et de l'élément de contact (2) qui participent à la liaison (3), la liaison (3) étant réalisée sans matière de liaison,
la liaison étant formée par une liaison de diffusion par liaison de matières entre la matière de l'électrode et la matière de l'élément de contact,
l'élément de contact (2) étant un fil métallique qui possède une zone de raccordement (6) dans laquelle il est relié directement à l'électrode (11), mécaniquement et de manière électriquement conductrice,
la liaison (3) entre l'électrode (11) et l'élément de contact (2) possédant plusieurs zones de liaison (5) locales délimitées les unes des autres, et la zone de raccordement (6) formant une zone cohérente dans laquelle sont disposées les zones de liaison (5).

2. Dispositif (100) selon la revendication 1, une surface de l'élément de contact (2) à laquelle fait face l'électrode possédant une zone de surface en métal précieux dans une zone de raccordement (6) dans laquelle est formée la liaison (3).

3. Dispositif (100) selon la revendication 1 ou 2,
l'élément de contact (2) étant aplati (7) dans la zone dans laquelle est formée la liaison (3).

4. Composant électronique, comprenant un dispositif selon au moins l'une des revendications précédentes, le corps de base (1) contenant une céramique ou possédant un corps en semiconducteur.

5. Composant électronique, comprenant un dispositif selon au moins l'une des revendications 1 à 3, lequel possède en outre une enveloppe (8) autour de la liaison (3), l'enveloppe (8) étant disposée et configurée de telle sorte qu'elle protège la liaison (3) contre l'effet des forces externes.

6. Procédé pour établir une liaison électriquement conductrice et mécanique entre un corps de base (1), qui possède une électrode (11), et un élément de contact (2), comprenant les étapes suivantes :
- fourniture du corps de base (1) pourvu de l'électrode (11) et fourniture de l'élément de contact (2)
- mise en contact mécanique direct de l'électrode (11) et de l'élément de contact (2) dans une zone de contact (10),
- application d'une force mécanique et de chaleur à la zone de contact (10), de sorte que la liaison (3) électriquement conductrice et mécanique entre l'électrode (11) et l'élément de contact (10) soit formée dans la zone de contact (10),
la liaison étant formée par une liaison de diffusion par liaison de matières entre la matière de l'électrode et la matière de l'élément de contact,
l'élément de contact (2) étant un fil métallique qui possède une zone de raccordement (6) dans laquelle il est relié directement à l'électrode (11), de manière électriquement conductrice et mécaniquement,
la liaison (3) entre l'électrode (11) et l'élément de contact (2) possédant plusieurs zones de liaison (5) locales délimitées les unes des autres, et la zone de raccordement (6) formant une zone cohérente dans laquelle sont disposées les zones de liaison (5).

7. Procédé selon la revendication 6, la zone de contact (10), en vue de former la liaison (6), étant exclusivement soumise à la force mécanique et à la chaleur.

8. Procédé selon la revendication 6 ou 7, la température de la charge thermique et la force mécanique étant choisies de telle sorte qu'il se produit une diffusion de matière, par laquelle l'élément de contact (2) est relié à l'électrode (11) de manière mécaniquement stable et électriquement conductrice.

9. Procédé selon au moins l'une des revendications 6 à 8, la température pour la charge thermique étant inférieure à la température de fusion de la matière de l'électrode et/ou inférieure à la température de fusion de la matière de l'élément de contact (2) proposée pour la liaison (3).

10. Procédé selon au moins l'une des revendications 6 à 9, la charge thermique étant effectuée à des températures entre 350 °C et 550 °C.

11. Procédé selon au moins l'une des revendications 6 à 10, lequel comporte, après la liaison mécanique directe, l'enveloppement de la liaison (3), par exemple avec un corps moulé (8) en vue de la stabilisation mécanique de l'élément de contact (2).
